# EUROPEAN PATENT APPLICATION

(11) **EP 4 246 655 A1**
(43) Date of publication of application: **20.09.2023**
(21) Application number: 22779023.5
(22) Date of filing: 30.03.2022
(51) Int. Cl.: H01M 10/42

(54) **SAMPLING STRUCTURE, BATTERY PACK, AND ELECTRIC VEHICLE**

(30) Priority: 30.03.2021 CN 202120653606 U
(71) Applicant: BYD Company Limited, Shenzhen, Guangdong 518118 (CN)
(72) Inventor: GAO, Jian, Shenzhen Guangdong 518118 (CN); PENG, Qingbo, Shenzhen Guangdong 518118 (CN); E, Congji, Shenzhen Guangdong 518118 (CN); XIONG, Bojun, Shenzhen Guangdong 518118 (CN); JIANG, Yongjun, Shenzhen Guangdong 518118 (CN)
(74) Representative: Arnold & Siedsma
(86) International application number: PCT/CN2022/084079
(87) International publication number: WO 2022/206841

(57) **Abstract**

The present disclosure provides a sampling structure, a battery pack, and an electric vehicle. The sampling structure includes a battery information collector, a plurality of fuses, and a plurality of collection lines. First ends of the collection lines are configured to be connected with corresponding batteries. Connection terminals are arranged on second ends of the collection lines. A plurality of pads are arranged on the battery information collector. First ends of the fuses are welded to the corresponding connection terminals. Second ends of the fuses are welded to the corresponding pads. The collection lines and the battery information collector in the present disclosure are welded through the fuses. The fuses not only can provide connection, but also can provide overcurrent protection.

## Description

### CROSS-REFERENCE TO RELATED APPLICATIONS

The present disclosure claims priority to Chinese Patent Application No. 202120653606.0, filed on March 30, 2021 and entitled "SAMPLING STRUCTURE, BATTERY PACK, AND ELECTRIC VEHICLE". The entire content of the above-referenced application is incorporated herein by reference.

### FIELD

The present disclosure relates to the field of batteries, and in particular, to a sampling structure, a battery pack, and an electric vehicle.

### BACKGROUND

In the related art, a sampling structure is arranged inside a battery pack to collect relevant information of batteries (including but not limited to a temperature and a voltage). Generally, the sampling structure is connected with a battery information collector through insertion, and the battery information collector is connected with a battery management system. The battery information collector receives sampling information and converts the sampling information and transmits the sampling information to the battery management system to help a user learn current working status of the batteries.

However, the connection between the sampling structure and the battery information collector in the above manner has low reliability, and additional fuses need to be arranged to ensure the safety of the entire circuit, resulting in an increase in the costs of the battery pack.

### SUMMARY

The content of the present disclosure is intended to resolve at least one technical problem in the related art. In a first aspect of the present disclosure, a sampling structure is provided. The sampling structure includes a battery information collector, multiple fuses, and multiple collection lines. First ends of the collection lines are configured to be connected with corresponding batteries. Connection terminals are arranged on second ends of the collection lines. Multiple pads are arranged on the battery information collector. First ends of the fuses are welded to the corresponding connection terminals. Second ends of the fuses are welded to the corresponding pads.

In some embodiments of the present disclosure, the fuses are welded to the connection terminals and the pads through bonding. The fuses are aluminum wires.

In some embodiments of the present disclosure, the fuses are arch-shaped.

In some embodiments of the present disclosure, the sampling structure further includes an insulating layer wrapped around the multiple collection lines. The insulating layer includes a first insulating layer and a second insulating layer arranged on two opposite sides of the multiple collection lines. Multiple through holes are provided on the first insulating layer. Parts of the collection lines exposed from the corresponding through holes constitute the connection terminals.

In some embodiments of the present disclosure, the sampling structure further includes a reinforcing plate. The reinforcing plate is fixed to a side of the second insulating layer facing away from the first insulating layer. Projections of the connection terminals on the second insulating layer are located within a projection range of the reinforcing plate on the second insulating layer.

In some embodiments of the present disclosure, the battery information collector is arranged on a side of the reinforcing plate facing away from the second insulating layer. The multiple pads are arranged on a side of the battery information collector facing the reinforcing plate. Multiple first through holes are provided on the sampling structure. The pads are exposed from the corresponding first through holes. The second ends of the fuses extend through the corresponding first through holes and are welded to the corresponding pads.

In some embodiments of the present disclosure, the battery information collector is arranged on a side of the first insulating layer facing away from the second insulating layer. The multiple pads are arranged on a side of the battery information collector facing away from the first insulating layer. Multiple second through holes are provided on the battery information collector. The connection terminals are exposed from the corresponding second through holes. The first ends of the fuses extend through the corresponding second through holes and are welded to the corresponding connection terminals.

In some embodiments of the present disclosure, the first insulating layer, the second insulating layer, and the multiple collection lines are constructed as a flexible flat cable (FFC) or a flexible printed circuit (FPC).

In some embodiments of the present disclosure, collection terminals are arranged on the first ends of the collection lines. The collection lines are connected with the corresponding batteries through the corresponding collection terminals.

Parts of the collection lines extend out of the insulating layer to form the collection terminals, or parts of the collection lines are exposed from the insulating layer and are welded to the collection terminals.

The collection lines are metal conductors. The collection terminals are metal sheets.

In some embodiments of the present disclosure, the multiple fuses and the multiple collection lines constitute a sampling assembly. The sampling structure includes multiple sampling assemblies. The battery information collector has multiple welding areas. The multiple pads are arranged in the welding areas. The pads in the welding areas are welded to the corresponding collection lines through the fuses of the corresponding sampling assemblies.

In some embodiments of the present disclosure, the multiple sampling assemblies and the pads in the multiple welding areas are arranged in a length direction of the battery information collector.

In another aspect, the present disclosure further provides a battery pack. The battery pack includes a housing, a battery management system, multiple electrically connected batteries, and the sampling structure in any of the above embodiments. The sampling structure and the multiple batteries are arranged within the housing. The sampling structure is connected with the battery management system and the multiple batteries.

In still another aspect, the present disclosure further provides an electric vehicle, including a vehicle body and the battery pack in any of the above embodiments. The battery pack is fixed to the vehicle body, or the box of the battery pack is constituted as a part of the vehicle body.

Beneficial effects of the present invention are as follows: In the sampling structure of the present disclosure, the first ends of the collection lines are configured to be connected with corresponding batteries, the connection terminals are arranged on the second ends of the collection lines, the multiple pads are arranged on the battery information collector, the first ends of the fuses are welded to the corresponding connection terminals, and the second ends of the fuses are welded to the corresponding pads. Compared to insertion, welding can ensure the reliability of the connection between the collection lines and the battery information collector. In addition, through the fuses, not only the connection between the collection lines and the battery information collector can be realized, but also overcurrent protection can be realized, which reduces a number of structural components, reduce the costs of the battery pack, and ensure the safety of the entire sampling circuit. Moreover, the collection lines may transmit collected battery information to the battery information collector. The battery information collector may convert the collected battery information and then transmit the collected battery information to the battery management system. In this way, a working status of the batteries may be monitored, thereby improving the safety of the battery pack.

Additional aspects and advantages of the present disclosure will be given in the following description, some of which will become apparent from the following description or may be learned from practices of the present disclosure.

### BRIEF DESCRIPTION OF THE DRAWINGS

FIG. 1 is an exploded view of a battery pack according to an embodiment of the present disclosure;
FIG. 2 is a schematic diagram of connection between a sampling structure and a battery according to an embodiment of the present disclosure (in which a battery information collector and a fuse are omitted);
FIG. 3 is an exploded view of FIG. 2;
FIG. 4 is a partial enlarged view of a part A in FIG. 3;
FIG. 5 is a schematic diagram of the sampling structure according to an embodiment of the present disclosure;
FIG. 6 is a partially enlarged view of a position B in FIG. 5;
FIG. 7 is a schematic structural diagram of a battery information collector in FIG. 5;
FIG. 8 is a schematic structural diagram of a sampling structure according to another embodiment of the present disclosure;
FIG. 9 is a partial enlarged view of a part B in FIG. 8;
FIG. 10 is a schematic structural diagram of a battery information collector in FIG. 9; and
FIG. 11 is a schematic structural diagram of an electric vehicle according to an embodiment of the present disclosure.

Reference numerals:
1000. Electric vehicle;
100. Battery pack; 200. Vehicle body;
10. Sampling structure; 101. Battery information collector; 102. Fuse; 103. Collection line; 1031. First end of collection line; 1032. Second end of collection line; 104. Connection terminal; 105. Pad; 106. Insulating layer; 107. First insulating layer; 108. Second insulating layer; 109. Through hole; 110. Reinforcing plate; 111. First through hole; 112. Second through hole; 113. First bendable portion; 114. Connection member; 115. Connection hole; 116. Collection terminal; 117. Second bendable portion; 118. Welding area; 119. Sampling assembly;
20. Battery; 201. First electrode; 202. Second electrode;
30: Housing;
40. Battery management system.

### DETAILED DESCRIPTION

Embodiments of the present disclosure are described in detail below, and examples of the embodiments are shown in drawings. The same or similar elements or the elements having same or similar functions are denoted by the same or similar reference numerals throughout the description. The embodiments described below with reference to the drawings are exemplary and used only for explaining the present disclosure, and should not be construed as a limitation on the present disclosure.

In the description of the present disclosure, it is to be understood that orientation or position relationships indicated by terms such as "center", "longitudinal", "transverse", "length", "width", "thickness", "upper", "lower", "front", "rear", "left", "right", "vertical", "horizontal", "top", "bottom", "interior", "exterior", "axial", and "circumferential" are based on orientation or position relationships shown in the drawings, are merely used to facilitate the description of the present disclosure and simplify the description, instead of indicating or implying that the indicated apparatus or element needs to have particular orientations or be constructed and operated in particular orientations, and therefore cannot be construed as a limitation on the present disclosure.

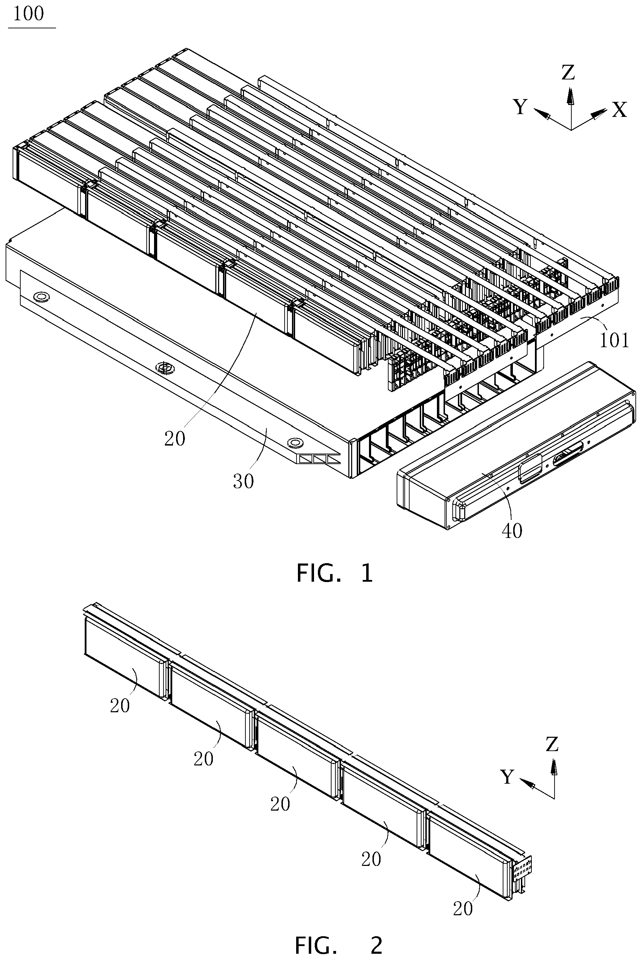

As shown in FIG. 1 to FIG. 5, the present disclosure provides a battery pack 100, including a sampling structure 10, a housing 30, a battery management system 40, and electrically connected batteries 20. The sampling structure 10 and the multiple batteries 20 are arranged inside the housing 30, and the sampling structure 10 is connected with the battery management system 40 and the multiple batteries 20.

The sampling structure 10 includes a battery information collector 101, multiple fuses 102, and multiple collection lines 103. First ends 1031 of the collection lines 103 are configured to be connected with corresponding batteries 20. Connection terminals 104 are arranged on second ends 1032 of the collection lines 103. Multiple pads 105 are arranged on the battery information collector 101. First ends of the fuses 102 are welded to the corresponding connection terminals 104. Second ends of the fuses 102 are welded to the corresponding pads 105.

In the sampling structure 10 of the present disclosure, the first ends 1031 of the collection lines 103 are configured to be connected with corresponding batteries 20, the connection terminals 104 are arranged on the second ends 1032 of the collection lines 103, the multiple pads 105 are arranged on the battery information collector 101, the first ends of the fuses 102 are welded to the corresponding connection terminals 104, and the second ends of the fuses 102 are welded to the corresponding pads 105. Compared to insertion, welding can ensure the reliability of the connection between the collection lines 103 and the battery information collector 101. In addition, through the fuses 102, not only the connection between the collection lines 103 and the battery information collector 101 can be realized, but also overcurrent protection can be realized, which reduces a number of structural components, reduce the costs of the battery pack 100, and ensure the safety of the entire sampling circuit. Moreover, the collection lines 103 may transmit collected battery information 20 to the battery information collector 101. The battery information collector 101 may convert the collected battery information and then transmit the collected battery information to the battery management system 40. In this way, a working status of the batteries 20 may be monitored, thereby improving the safety of the battery pack 100.

The connection between the battery information collector 101 and the battery management system 40 is a frequently used in the art. Details are not described herein.

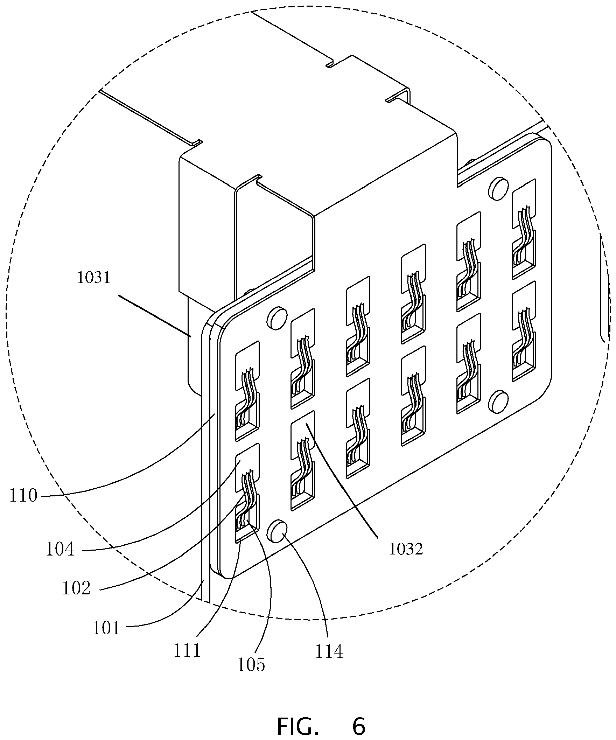

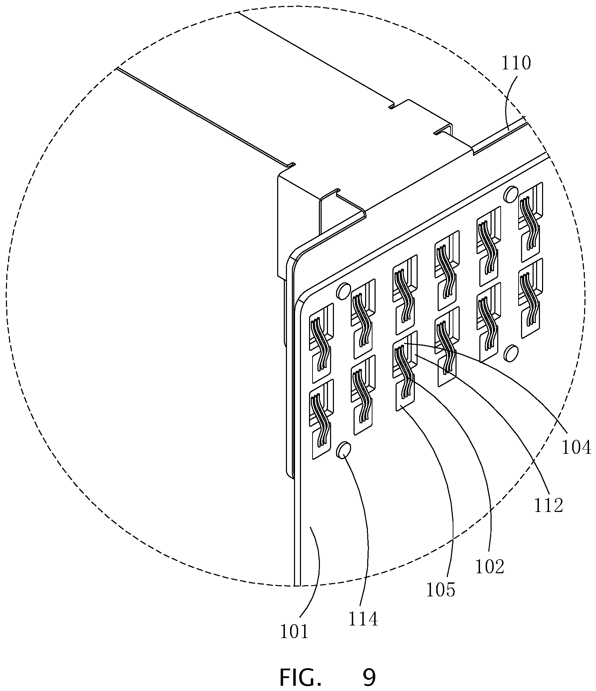

In some embodiments, as shown in FIG. 6 and FIG. 9, the fuses 102 are welded to the connection terminals 104 and the pads 105 thorough bonding. The fuses 102 are aluminum wires, which can reduce the production costs.

Each of the connection terminals 104 and each of the pads 105 may be connected through one fuse 102 or multiple fuses 102. A specific number may be set according to actual use requirements.

In some embodiments, as shown in FIG. 6 and FIG. 9, the fuses 102 are arch-shaped, which can reduce a risk of short circuits caused by overlapping between the fuses 102 and other structures, thereby improving the safety.

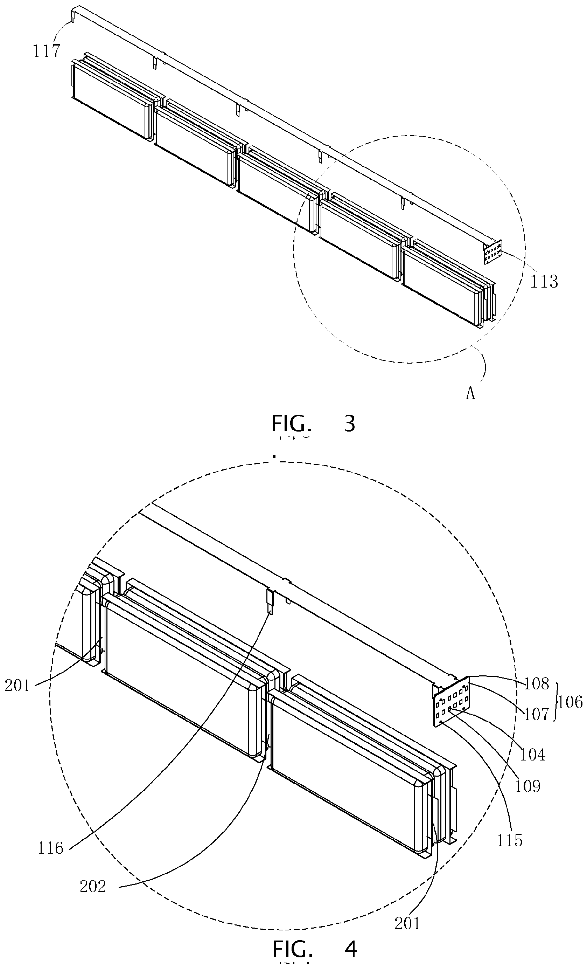

In some embodiments, as shown in FIG. 3 and FIG. 4, the sampling structure 10 further includes an insulating layer 106 wrapped around the multiple collection lines 103. The insulating layer 106 includes a first insulating layer 107 and a second insulating layer 108 arranged on two opposite sides of the multiple collection lines 103. Multiple through holes 109 are provided on the first insulating layer 107. Parts of the collection lines 103 exposed from the corresponding through holes 109 constitute the connection terminals 104. The collection lines 103 are metal conductors. As shown in FIG. 4, twelve collection lines 103 are arranged, and correspondingly, twelve through holes 109 are provided. A part of each of the collection lines 103 exposed from the corresponding through hole 109 constitutes a connection terminal 104.

In some embodiments, the multiple through holes 109 on the first insulating layer 107 are distributed in multiple rows, and correspondingly, the multiple connection terminals 104 are distributed in multiple rows. In this way, the arrangement of the connection terminals 104 can be more compact, which reduces the size of the sampling structure 10. As shown in FIG. 1 to FIG. 4, the multiple through holes 109 are arranged in a direction Z. The direction Z may be the same as a width direction of the battery information collector 101 or a height direction of the battery pack 100.

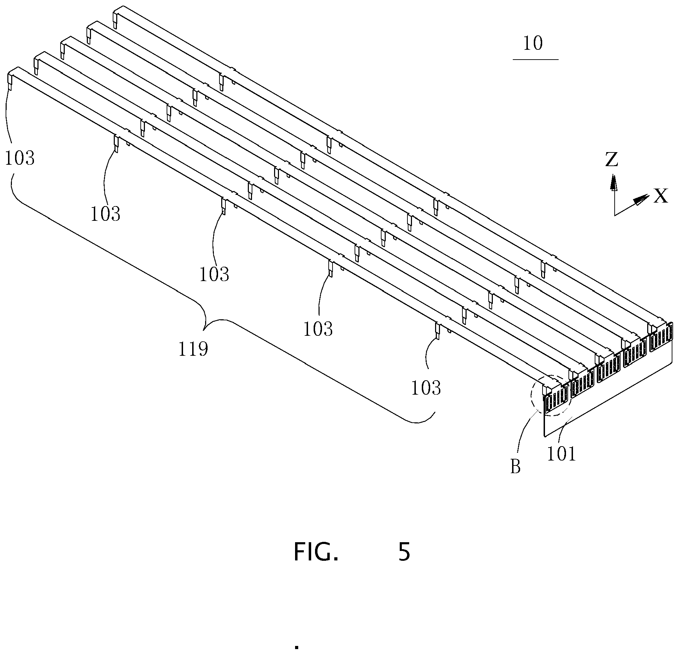

In some embodiments, as shown in FIG. 5 and FIG. 6, the sampling structure 10 further includes a reinforcing plate 110. The reinforcing plate 110 is fixed to a side of the second insulating layer 108 facing away from the first insulating layer 107. Projections of the connection terminals 104 on the second insulating layer 108 are located within a projection range of the reinforcing plate 110 on the second insulating layer 108. In other words, the projections of the connection terminals 104 on the reinforcing plate 110 are located within a profile range of the reinforcing plate 110. In this way, when the connection terminals 104 are welded to the pads 105, the reinforcing plate 110 can support connection terminals 104, which improves the reliability of the welding.

In some embodiments, as shown in FIG. 5 to FIG. 7, the battery information collector 101 is arranged on a side of the reinforcing plate 110 facing away from the second insulating layer 108. The multiple pads 105 are arranged on a side of the battery information collector 101 facing the reinforcing plate 110. Multiple first through holes 111 are provided on the sampling structure 10. The pads 105 are exposed from the corresponding first through holes 111. The second ends of the fuses 102 extend through the corresponding first through holes 111 and are welded to the corresponding pads 105.

As shown in FIG. 5 and FIG. 6, the multiple first through holes 111 and the multiple connection terminals 104 are arranged alternately in the width direction of the battery information collector 101. In this way, the first through holes 111 and the connection terminals 104 on the sampling structure 10 can be more compact, which facilitates miniaturization of the sampling structure 10.

The width direction of the battery information collector 101 is the same as the direction Z. The direction may be the same as the height direction of the battery pack 100.

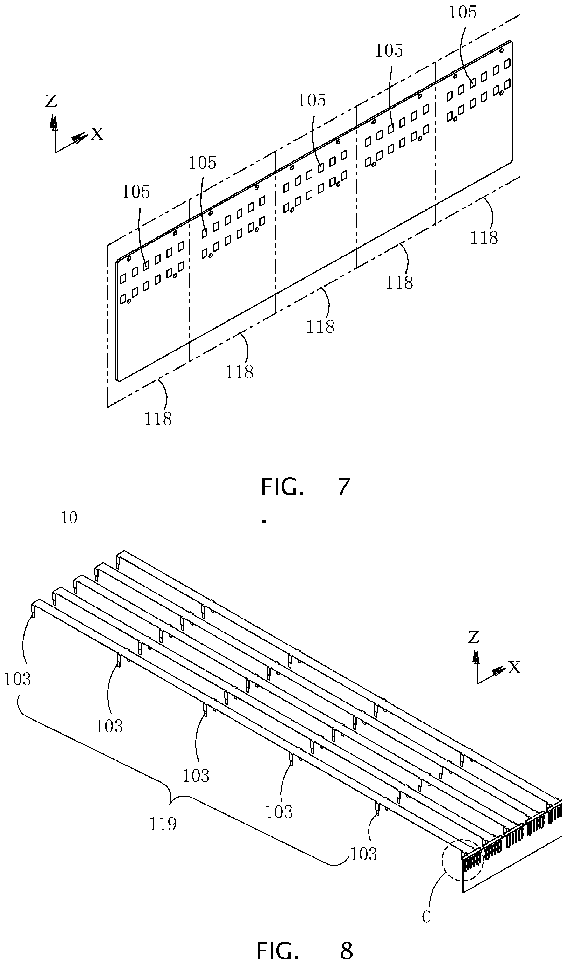

In some embodiments, as shown in FIG. 8 to FIG. 10, the battery information collector 101 is arranged on a side of the first insulating layer 107 facing away from the second insulating layer 108. The multiple pads 105 are arranged on a side of the battery information collector 101 facing away from the first insulating layer 107. Multiple second through holes 112 are provided on the battery information collector 101. The connection terminals 104 are exposed from the corresponding second through holes 112. The first ends of the fuses 102 extend through the corresponding second through holes 112 and are welded to the corresponding connection terminals 104.

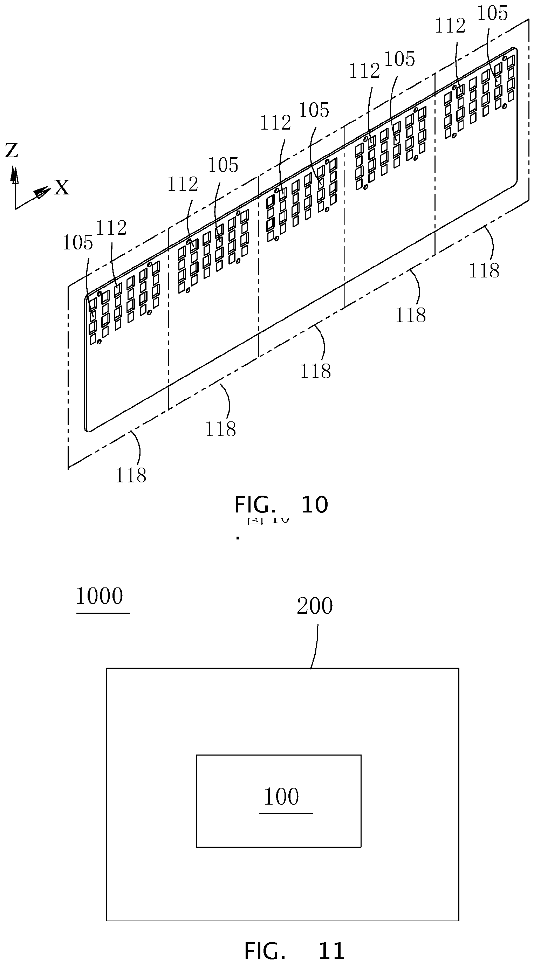

As shown in FIG. 10, the multiple second through holes 112 and the multiple pads 105 are arranged alternately in the width direction of the battery information collector 101. In this way, the arrangement of the second through holes 112 and the pads 105 on the battery information collector 101 can be more compact, which facilitating miniaturization of the battery information collector 101.

The width direction of the battery information collector 101 extends in the direction Z. The direction may be the same as the height direction of the battery pack 100.

In some embodiments, as shown in FIG. 5 to FIG. 10, the multiple fuses 102 and the multiple collection lines 103 constitute a sampling assembly 119. The sampling structure 10 includes multiple sampling assemblies 119. The battery information collector 101 has multiple welding areas 118. The multiple pads 105 are arranged in the welding areas 118. The pads 105 in the welding areas 118 are welded to the corresponding collection lines 103 through the fuses 102 of the corresponding sampling assemblies 119.

Specifically, the pads 105 in each of the welding areas 118 are welded to the first ends of the fuses 102 of the corresponding sampling assembly 119, and the second ends of the fuses 102 are welded to the connection terminals 104 of the collection lines 103 of the sampling assembly 119.

Further, as shown in FIG. 8 and FIG. 10, the pads 105 on the multiple sampling assemblies 119 and the multiple welding areas 118 are arranged in the length direction of the battery information collector 101. A length of the battery information collector 101 extends along in a direction X. The direction X may be the same as the width direction of the battery pack 100. In this way, the design of the sampling structure 10 can be more compact, thereby facilitating subsequent assembly.

In some embodiments, as shown in FIG. 3 and FIG. 4, first bendable portions 113 are arranged on the second ends 1032 of the collection lines 103. The connection terminals 104 are arranged on the first bendable portions 113. The first insulating layer 107 and the second insulating layer 108 each include a first part corresponding to the first bendable portions 113. The through holes 109 are located on the first part of the first insulating layer 107, and the reinforcing plate 110 is fixed to the first part of the second insulating layer 108. The bendable structure design may facilitate connection of the collection lines 103 to the battery information collector 101.

In some embodiments, as shown in FIG. 5 and FIG. 6, the sampling structure 10 further includes a connection member 114. The connection member 114 is configured to fixedly connect the sampling structure 10 to the battery information collector 101.

For example, the connection member 114 is a rivet, and both the sampling structure 10 and the battery information collector 101 are provided with a connection hole 115. The rivet is fixed in the connection hole 115 to connect the sampling structure 10 to the battery information collector 101. Certainly, in other embodiments, the connection member 114 may be a structural adhesive, and the sampling structure 10 and the battery information collector 101 are connected through the structural adhesive.

In some embodiments, the first insulating layer 107, the second insulating layer 108, and the multiple collection lines 103 are constructed as a flexible printed circuit (FPC).

The FPC includes metal foil and insulating films covering two sides of the metal foil. The metal foil is etched to form the multiple collection lines 103, and the two insulating films constitute the first insulating layer 107 and the second insulating layer 108 respectively.

In some embodiments, the first insulating layer 107, the second insulating layer 108, and the multiple collection lines 103 are constructed as a flexible flat cable (FFC).

The FFC includes multiple metal conductors and protective films covering two sides of the multiple metal conductors. The metal conductors are bonded between the two protective films. The metal conductors form the collection lines 103, and the two protective films constitute the first insulating layer 107 and the second insulating layer 108 respectively.

In some embodiments, collection terminals 116 are arranged on the first ends 1031 of the collection lines 103. The collection lines 103 are connected with the corresponding batteries 20 through the corresponding collection terminals 116. As shown in FIG. 3 and 6, parts of the collection lines 103 extend out of the insulating layer 106 to form the collection terminals 116.

Certainly, in other embodiments, parts of the collection lines 103 may be exposed from the insulating layer 106 and welded to the collection terminals 116.

The collection lines 103 are metal conductors. The collection terminals 116 are metal sheets.

In some embodiments, as shown in FIG. 2 to FIG. 4, the multiple batteries 20 are arranged in sequence and connected in series in a direction Y. Each of the batteries 20 includes a first electrode 201 and a second electrode 202 for leading out current. The first electrode 201 and second electrode 202 are distributed on two opposite sides of the battery 20, and the collection lines 103 are connected with the first electrodes 201 or second electrodes 202 of the corresponding batteries 20 through the corresponding collection terminals 116. The length direction of the battery pack 100 is the same as the direction Y.

In some other embodiments, the batteries 20 are connected through conductive sheets, and the collection lines 103 are connected with the corresponding conductive sheets through the corresponding collection terminals 116.

In some embodiments, as shown in FIG. 2 to FIG. 4, second bendable portions 117 are arranged on the first ends 1031 of the collection lines 103. The collection terminals 116 are arranged on the second bendable portions 117. The bendable structure design may facilitate connection of the collection lines 103 to the batteries 20.

In another aspect, as shown in FIG. 11, the present disclosure further provides an electric vehicle 1000, including a vehicle body 200 and the battery pack 100 in any of the above embodiments. The battery pack 100 may be fixed to the vehicle body 200, or the housing 30 of the battery pack 100 is constituted as a part of the vehicle body 200. For example, the housing 30 constitutes the floor of the vehicle body 200.

In the description of the present disclosure, it should be noted that unless otherwise explicitly specified and defined, terms "mount", "connect", and "connection" should be understood in a broadest sense, for example, a fixed connection, a detachable connection, an integral connection, or may be a mechanical connection or an electrical connection; or may be a direct connection, an indirect connection through a middle medium, or interior communication between two elements. A person of ordinary skill in the art may understand the specific meanings of the terms in the present disclosure according to specific situations.

In the description of this specification, description with reference to terms such as "an embodiment", "specific embodiments", or "an example", means in combination with the embodiment or example including specific features, structures, materials, or features described in at least one embodiment or example of the present disclosure. In this specification, schematic descriptions of the above terms do not necessarily refer to the same embodiment or example. In addition, the described specific features, structures, materials, or characteristics may be combined in a proper manner in any one or more embodiments or examples.

Although the embodiments of the present disclosure have been shown and described, a person of ordinary skill in the art should understand that various changes, modifications, replacements and variations may be made to the embodiments without departing from the principles and spirit of the present disclosure, and the scope of the present disclosure is as defined by the appended claims and their equivalents.

## Claims

1. A sampling structure (10), wherein the sampling structure (10) comprises a battery information collector (101), a plurality of fuses (102), and a plurality of collection lines (103);
first ends (1031) of the collection lines (103) are configured to be connected with corresponding batteries (20); connection terminals (104) are arranged on second ends (1032) of the collection lines (103);
a plurality of pads (105) are arranged on the battery information collector (101);
first ends of the fuses (102) are welded to the corresponding connection terminals (104); and second ends of the fuses (102) are welded to the corresponding pads (105).

2. The sampling structure (10) according to claim 1, wherein the fuses (102) are welded to the connection terminals (104) and the pads (105) through bonding; and the fuses (102) are aluminum wires.

3. The sampling structure (10) according to claim 1 or 2, wherein the fuses (102) are arch-shaped.

4. The sampling structure (10) according to any of claims 1 to 3, wherein the sampling structure (10) further comprises an insulating layer (106) wrapped around the plurality of collection lines (103); the insulating layer (106) comprises a first insulating layer (107) and a second insulating layer (108) arranged on two opposite sides of the plurality of collection lines (103); a plurality of through holes (109) are provided on the first insulating layer (107); and parts of the collection lines (103) exposed from the corresponding through holes (109) constitute the connection terminals (104).

5. The sampling structure (10) according to claim 4, wherein the sampling structure (10) further comprises a reinforcing plate (110); the reinforcing plate (110) is fixed to a side of the second insulating layer (108) facing away from the first insulating layer (107); and projections of the connection terminals (104) on the second insulating layer (108) are located within a projection range of the reinforcing plate (110) on the second insulating layer (108).

6. The sampling structure (10) according to claim 5, wherein the battery information collector (101) is arranged on a side of the reinforcing plate (110) facing away from the second insulating layer (108); the plurality of pads (105) are arranged on a side of the battery information collector (101) facing the reinforcing plate (110); a plurality of first through holes (111) are provided on the sampling structure (10); the pads (105) are exposed from the corresponding first through holes (111); and the second ends of the fuses (102) extend through the corresponding first through holes (111) and are welded to the corresponding pads (105).

7. The sampling structure (10) according to claim 5, wherein the battery information collector (101) is arranged on a side of the first insulating layer (107) facing away from the second insulating layer (108); the plurality of pads (105) are arranged on a side of the battery information collector (101) facing away from the first insulating layer (107); a plurality of second through holes (112) are provided on the battery information collector (101); the connection terminals (104) are exposed from the corresponding second through holes (112); and the first ends of the fuses (102) extend through the corresponding second through holes (112) and are welded to the corresponding connection terminals (104).

8. The sampling structure (10) according to claim 4, wherein the first insulating layer (107), the second insulating layer (108), and the plurality of collection lines (103) are constructed as a flexible flat cable (FFC) or a flexible printed circuit (FPC).

9. The sampling structure (10) according to claim 4, wherein collection terminals (116) are arranged on the first ends (1031) of the collection lines (103); the collection lines (103) are connected with the corresponding batteries (20) through the corresponding collection terminals (116);
parts of the collection lines (103) extend out of the insulating layer (106) to form the collection terminals (116), or parts of the collection lines (103) are exposed from the insulating layer (106) and are welded to the collection terminals (116);
the collection lines (103) are metal conductors; and the collection terminals (116) are metal sheets.

10. The sampling structure (10) according to any of claims 1 to 9, wherein the plurality of fuses (102) and the plurality of collection lines (103) constitute a sampling assembly (119); the sampling structure (10) comprises a plurality of sampling assemblies (119); the battery information collector (101) has a plurality of welding areas (118); the plurality of pads (105) are arranged in the welding areas (118); and the pads (105) in the welding areas (118) are welded to the corresponding collection lines (103) through the fuses (102) of the corresponding sampling assemblies (119).

11. The sampling structure (10) according to claim 10, wherein the plurality of sampling assemblies (119) and the pads (105) in the plurality of welding areas (118) are arranged in a length direction of the battery information collector (101).

12. A battery pack (100), wherein the battery pack (100) comprises a housing (30), a battery management system (40), a plurality of electrically connected batteries (20), and the sampling structure (10) according to any of claims 1 to 11; the sampling structure (10) and the plurality of batteries (20) are arranged within the housing (30); and the sampling structure (10) is connected with the battery management system (40) and the plurality of batteries (20).

13. An electric vehicle (1000), wherein the electric vehicle (1000) comprises a vehicle body (200) and the battery pack (100) according to claim 12; and the battery pack (100) is fixed to the vehicle body (200); or the housing (30) of the battery pack (100) forms a part of the vehicle body (200).
